# EUROPÄISCHE PATENTANMELDUNG

(11) **EP 0 902 297 A2**
(43) Veröffentlichungstag der Anmeldung: **17.03.1999**
(21) Anmeldenummer: 98116790.1
(22) Anmeldetag: 05.09.1998
(51) Int. Cl.: G01R 31/28, G01R 1/073, G01R 31/02

(54) **Adapteranordnungen zum Testen von Leiterplatten**

(30) Priorität: 11.09.1997 EP 97810646
(71) Anmelder: Photo Print Electronic GmbH, 79650 Schopfheim (DE)
(72) Erfinder: Kersten, Peter, Dr.-Ing., 79689 Maulburg (DE)
(74) Vertreter: Morstadt, Volker, Dipl.-Ing.

(57) **Zusammenfassung**

Diese Adapteranordnungen (3, 6) sind zum Testen von auch großflächigen, Leiterplatten (1) geeignet, deren n Testpunkte (211 ... 281) nur einen Abstand von etwa 150 µm haben können. Eine einschichtige flexible Folie (30) aus Isoliermaterial hat n Kontaktbumps (311 ...381) mit einem Kontaktierungsteil (3111) und einer Längsachse (3112). Jeder Kontaktbump führt durch die Folie senkrecht hindurch, überragt die Vorderseite einstufig und sitzt derart in einer Bohrung, daß die Längsachse mit deren Mittelachse zusammenfällt. Während des Testens wird jeder Kontaktbump mit dem zugehörigen Testpunkt durch flächiges Andrücken der Folie (30) an die Leiterplatte (1) mechanisch in Berührung gebracht und dadurch elektrisch kontaktiert. Jeweils ein Leiterzug (411, 421, 481) verläuft auf der Rückseite der Folie von einem entsprechenden Kontaktbump zu einem zugehörigen Kontaktpunkt (511, 521, 581). Jeder Kontaktpunkt ist mit einer entsprechenden Kontaktnadel eines Eingangskontaktfelds des Testgeräts mittels dessen Andrückens an die Rückseite der Folie (30) unter Zwischenlage einer elektrisch isolierenden, elastisch federnden Zwischenfolie (34) elektrisch kontaktiert, die dort, wo eine Kontaktnadel einen Kontaktpunkt zu kontaktieren hat, eine elektrische Durchkontaktierung aufweist.

## Beschreibung

Die Erfindung betrifft Adapteranordnungen zum Testen von mindestens einlagigen, unbestückten Leiterplatten.

Nach der Herstellung dieser Leiterplatten, also wenn deren Leiterbahnen fertiggestellt wurden, ist es erforderlich, jede dieser Leiterplatten mindestens in zweierlei Hinsicht elektrisch zu testen. Einerseits ist zu testen, ob Leiterbahnen, die voneinander isoliert sein sollen, auch voneinander isoliert sind und nicht einen unzulässig niederen Isolationswiderstand gegeneinander aufweisen, insb. kurzgeschlossen sind. Andererseits ist zu testen, ob die einzelnen Leiterbahnen auf ihrem Verlauf auch leitend sind und nicht einen unzulässig hohen Widerstand haben, insb. ob sie unterbrochen sind.

Das Testen nach dem Herstellen ist auch in der Halbleiter-Technik üblich und erforderlich, die mit der Technik der Herstellung von Leiterplatten, wenn überhaupt, nur wenig gemeinsam hat. So werden bekanntlich in einem Silicium-Wafer nach der Planartechnik eine Vielzahl von einzelnen integrierten Schaltungen (= Einzel-ICs) dadurch erzeugt, daß im Bereich des jeweiligen Einzel-ICs an seiner Oberfläche mittels Aluminium-Leitbahnen untereinander elektrisch verbundene Halbleiterzonen erzeugt werden.

Die Aluminium-Leitbahnen führen zu am Rand des Einzel-ICs angeordneten Aluminium-Pads. Beim Testen werden auf die Pads harte Spitzen praktisch senkrecht aufgesetzt, die zu federnden, meist schräg zur Oberfläche der Pads gerichteten Kontaktnadeln gehören. Die Kontaktnadeln sind Bestandteil einer Adapteranordnung, die die Kontaktnadeln elektrisch mit einem Meßgerät verbindet. An der Adapteranordnung sind die Kontaktnadeln auf die Pads justierbar gehaltert.

Die Spitzen sind erforderlich, um die an der Oberfläche von Aluminium immer vorhandene Aluminiumoxid-Schicht sicher durchstoßen zu können, da erst dann ein erforderlicher, möglichst niederohmiger Kontakt mit den Pads erreicht wird. Die Adapteranordnung wird zu diesem Zweck solange auf die Pads zu bewegt, bis die schräg gerichteten Kontaktnadeln einen Federdruck auf die Spitzen und die Pads einwirken lassen.

Zur Vermeidung der genannten, auf die Testpunkte aufzusetzenden Kontaktnadeln ist in der WO-A 96/07924 eine zum Testen von noch nicht von einem Silicium-Wafer abgetrennten Einzel-ICs bestimmte Adapteranordnung beschrieben, wobei das Einzel-IC einen ersten, einen zweiten und einen n-ten auch als Testpunkt dienenden Pad aufweist, wobei die Pads an einem Rand des Einzel-ICs nebeneinanderliegen und wobei n eine beliebig vorgebbare ganze Zahl ist, welche Adapteranordnung umfaßt:
- eine als Membran wirkende, mehrschichtige flexible Folie aus Isoliermaterial mit
   -- einer Vorder- und einer Rückseite,
   -- einer an der Vorderseite liegenden Vorderseiten-Schicht,
   -- einer an der Rückseite liegenden Rückseiten-Schicht,
   -- einer zwischen der Vorderseiten- und der Rückseiten-Schicht angeordneten Mittelschicht,
   -- einem ersten, einem zweiten und einem n-ten elektrisch leitenden Kontaktbump mit einer Längsachse und einem Kontaktierungsteil, der an seinem Ende harte, spitze Mikrovorsprünge trägt, welcher Kontaktbump
      --- durch die Vorderseiten-Schicht in einer Bohrung, die eine Mittelachse hat, zur Vorderseite senkrecht hindurchführt,
      --- die Vorderseite in zwei Stufen derart überragt,
         ---- daß eine erste Stufe eine seitliche elektrische Verbindung zum Kontaktierungsteil herstellt und
         ---- daß der Kontaktierungsteil gegenüber der Bohrung seitlich versetzt ist,
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- einer den ersten Kontaktbump kontaktierenden, auf einer von der Vorderseite abgewandten Seite der Vorderseiten-Schicht verlaufenden ersten Leiterbahn,
   -- einer den zweiten Kontaktbump kontaktierenden, auf der von der Vorderseite abgewandten Seite der Vorderseiten-Schicht verlaufenden zweiten Leiterbahn und
   -- einer den n-ten Kontaktbump kontaktierenden, auf der von der Vorderseite abgewandten Seite der Vorderseiten-Schicht verlaufenden n-ten Leiterbahn,
      --- von denen die erste Leiterbahn mit einem ersten Kontaktpad, die zweite Leiterbahn mit einem zweiten Kontaktpad und die n-te Leiterbahn mit einem n-ten Kontaktpad dauernd verbunden ist, und
- eine Blattfedervorrichtung,
   -- mit der die Membran über einen Stempel flächig an die Pads gedrückt werden kann und
   -- deren Federkraft einstellbar ist.

Das oben erwähnte Kontaktierungsproblem, eine Aluminiumoxid-Schicht durchstoßen zu müssen, tritt beim Testen von Leiterplatten nicht auf, da bei diesen bekanntlich andere Metalle als Aluminium für die Leiterbahnen, nämlich insb. nickel/gold-, zinn- oder blei/zinn-beschichtetes Kupfer, verwendet werden. Vielmehr ergeben sich beim Testen von Leiterplatten schon aufgrund ihrer gegenüber der Fläche von Einzel-ICs erheblich größeren zu testenden Fläche andere Probleme, die zu lösen sind.

So haben heutige Einzel-ICs eine Fläche von ca. 10 mm mal 10 mm, während Leiterplatten bis zu 400 mm mal 400 mm und mehr groß sein können. Zudem sind Testpunkte, die den erwähnten Pads entsprechen, meist nicht am Rand der Leiterplatte angeordnet, sondern über deren Fläche beliebig verteilt. Auch ist die Anzahl der Testpunkte wesentlich größer als die der Pads von Einzel-ICs.

Ferner sind Leiterplatten aufgrund ihrer großen Flächen über die gesamte Fläche betrachtet erheblich weniger eben als die erwähnten Einzel-ICs und auch nicht verwindungsfrei. Nach einem internationalen Standard (IPC-TM-650; IPC = Institute of Printed Circuits) ist nämlich eine Verwölbung und Verwindung von kleiner als 1,5 % der längsten Abmessung der Leiterplatte zugelassen.

Das Aufsetzen von Kontaktnadeln auf Leiterplatten zu deren Testen ist daher praktisch unmöglich. Aber auch die zweistufigen Kontaktbumps nach der oben referierten WO-A 96/07924 sind aus den folgenden Gründen ungeeignet.

Wegen der erwähnten Unebenheit von Leiterplatten wurden Scherkräfte auf die Kontaktierungsteile der zweistufigen Kontaktbumps einwirken, so daß die ersteren leicht abbrechen könnten. Auch wären wegen der Unebenheit größere Federwege für gleiche Anpreßdrücke an die Leiterplatte als bei der für die sehr gut ebenen Einzel-ICs dimensionierten Adapteranordnung erforderlich.

In den Figuren der JP-A 3 - 237 369 und deren englischem Abstract ist eine Adapteranordnung zum elektrischen Anschluß von zu testenden, mindestens einlagigen, unbestückten Leiterplatten an ein Testgerät beschrieben, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus Isoliermaterial
   -- mit einer Vorderseite und einer Rückseite,
   -- mit einem ersten, einem zweiten und einem n-ten elektrisch leitenden Kontaktbump, der
      --- die Vorderseite einstufig überragt und
      --- zur Rückseite hin durch die Folie hindurch mittels mehrerer in einem Raster angeordneter, metallgefüllter Bohrungen und mittels mehreren auf der Rückseite der Folie verlaufenden Leiterzügen kontaktiert ist,
         ---- von denen je ein Leiterzug zu je einer Bohrung gehört, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist.

In der EP-A 147 245 ist schließlich eine Adapteranordnung zum elektrischen Anschluß von ausschließlich auf Unterbrechungen von Leiterbahnen zu testenden, mindestens einlagigen, unbestückten Leiterplatten an ein Testgerät beschrieben, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus Isoliermaterial
   -- mit einer Vorderseite und einer Rückseite,
   -- mit einem ersten, einem zweiten und einem n-ten elektrisch leitenden Kontaktbump, der
      --- die Vorderseite einstufig überragt und
      --- zur Rückseite hin durch die Folie hindurch mittels einer einzigen von mehreren in einem Raster angeordneten, metallgefüllten Bohrungen und mittels einer einzigen zugehörigen von mehreren auf der Rückseite der Folie verlaufenden Leiterzügen kontaktiert ist,
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist.

Eine Aufgabe der Erfindung besteht daher darin, zum Testen von, insb. auch großflächigen, Leiterplatten geeignete Adapteranordnungen anzugeben, die mit Kontaktbumps das Testen möglich machen, insb. wenn die Mitten der Testpunkte nur einen Abstand von etwa 150 µm haben, welcher Wert die Untergrenze dieser Abstände bei heute herstellbaren Leiterplatten darstellt.

Zur Lösung der oben genannten Aufgabe und der oben geschilderten Probleme besteht eine erste Variante der Erfindung in einer Adapteranordnung zum elektrischen Anschluß von zu testenden, mindestens einlagigen, unbestückten Leiterplatten an ein Testgerät, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus einem Isoliermaterial
   -- mit einer Vorder- und einer Rückseite,
   -- mit einem ersten, einem zweiten und einem n-ten elektrisch leitenden Kontaktbump mit einem Kontaktierungsteil und einer Längsachse, welcher Kontaktbump
      --- von der Rückseite zur Vorderseite durch die Folie in einer Bohrung, die eine Mittelachse hat, senkrecht hindurchführt,
      --- die Vorderseite einstufig überragt und
      --- derart in der Bohrung sitzt, daß die Längsachse mit deren Mittelachse zusammenfällt, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- mit einem den ersten Kontaktbump kontaktierenden, auf der Rückseite der Folie verlaufenden ersten Leiterzug,
   -- mit einem den zweiten Kontaktbump kontaktierenden, auf der Rückseite der Folie verlaufenden zweiten Leiterzug,
   -- mit einem den n-ten Kontaktbump kontaktierenden, auf der Rückseite der Folie verlaufenden n-ten Leiterzug,
      --- von denen der erste Kontaktpunkt mit einer ersten Kontaktnadel eines Eingangskontaktfelds des Testgeräts, der zweite Kontaktpunkt mit einer zweiten Kontaktnadel des Eingangskontaktfelds und der n-te Kontaktpunkt mit einer n-ten Kontaktnadel des Eingangskontaktfelds mittels dessen Andrückens an die Rückseite der Folie unter Zwischenlage einer elektrisch isolierenden, elastisch federnden Zwischenfolie elektrisch zu kontaktieren ist,
         ---- die dort, wo eine Kontaktnadel einen Kontaktpunkt zu kontaktieren hat, eine elektrische Durchkontaktierung aufweist.

Zur Lösung der oben genannten Aufgabe und der oben geschilderten Probleme besteht eine zweite Variante der Erfindung in einer Adapteranordnung zum elektrischen Anschluß von zu testenden, mindestens einlagigen, unbestückten Leiterplatten an ein Testgerät, die einen ersten, einen zweiten und einen n-ten Testpunkt aufweisen, wobei n eine beliebig vorgebbare ganze Zahl ist, welche Adapteranordnung umfaßt:
- eine einschichtige flexible Folie aus einem Isoliermaterial
   -- mit einer Vorder- und einer Rückseite sowie mit einem ersten und einem damit zusammenhängenden zweiten Teil,
   -- mit einem ersten, einem zweiten und einem n-ten elektrisch leitenden Kontaktbump mit einem Kontaktierungsteil und einer Längsachse, welcher Kontaktbump
      --- im ersten Teil der Folie angeordnet ist,
      --- von der Rückseite zur Vorderseite durch die Folie in einer Bohrung, die eine Mittelachse hat, senkrecht hindurchführt,
      --- die Vorderseite einstufig überragt und
      --- derart in der Bohrung sitzt, daß die Längsachse mit deren Mittelachse zusammenfällt, und
      --- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
   -- mit einem den ersten Kontaktbump kontaktierenden, auf der Rückseite der Folie verlaufenden ersten Leiterzug,
   -- mit einem den zweiten Kontaktbump kontaktierenden, auf der Rückseite der Folie verlaufenden zweiten Leiterzug,
   -- mit einem den n-ten Kontaktbump kontaktierenden, auf der Rückseite der Folie verlaufenden n-ten Leiterzug, von denen
      --- der erste Leiterzug bis zu einem ersten, im zweiten Teil der Folie liegenden Vorderseiten-Kontaktpunkt führt und mit diesem durch die Folie hindurch kontaktiert ist,
      --- der zweite Leiterzug bis zu einem zweiten, im zweiten Teil der Folie liegenden Vorderseiten-Kontaktpunkt führt und mit diesem durch die Folie hindurch kontaktiert ist, und
      --- der n-te Leiterzug zu bis einem n-ten, im zweiten Teil der Folie liegenden Vorderseiten-Kontaktpunkt führt und mit diesem durch die Folie hindurch kontaktiert ist, wobei
         ---- der erste Vorderseiten-Kontaktpunkt mit einer ersten Kontaktnadel eines Eingangskontaktfelds des Testgeräts, der zweite Vorderseiten-Kontaktpunkt mit einer zweiten Kontaktnadel des Eingangskontaktfelds und der n-te Vorderseiten-Kontaktpunkt mit einer n-ten Kontaktnadel des Eingangskontaktfelds durch Wenden des zweiten Teils der Folie um ca. 180° und mittels Andrückens des Eingangskontaktfelds an die Vorderseite der Folie im zweiten Teil unter Zwischenlage einer elektrisch isolierenden, elastisch federnden Zwischenfolie zwischen die Rückseite der Folie in deren erstem und zweitem Teil elektrisch zu kontaktieren ist.

Nach einer bevorzugten Ausgestaltung der ersten Variante der Erfindung sind die Durchkontaktierungen in Form von in Längsrichtung federnden Stiften oder in Form von elastischen leitenden Zylindern realisiert.

Ein Vorteil der Erfindung besteht darin, daß eine speziell für das Testen von Leiterplatten geeignete Adapteranordnung geschaffen wird, die alle an sie zu stellenden Anforderungen erfüllt und leicht mit den in der Leiterplattentechnik üblichen Verfahren herstellbar, also mit dieser Technik kompatibel ist.

Ein weiterer Vorteil ist, daß die Adapteranordnung der Erfindung aufgrund ihres Aufbaus auch bei doppelseitigen Leiterplatten ohne weiteres verwendet werden kann, wie unten noch ausführlich erläutert werden wird.

Die Erfindung und weitere Vorteile werden nun anhand von Ausführungsbeispielen näher erläutert, die in den Figuren der Zeichnung schematisch dargestellt sind; dabei sind Bezugszeichen, die anhand einer bestimmten Figur erläutert wurden, in folgenden Figuren nur noch wenn erforderlich wieder eingetragen.
- Fig. 1: zeigt perspektivisch eine Leiterplatte mit einem einfachen Layout,
- Fig. 2: zeigt perspektivisch eine Adapteranordnung entsprechend einer ersten Variante der Erfindung zusammen mit der Leiterplatte von Fig. 1,
- Fig. 3: zeigt im Schnitt einen Kontaktbump der Adapteranordnung, und
- Fig. 4: zeigt perspektivisch eine Adapteranordnung entsprechend einer zweiten Variante der Erfindung zusammen mit der Leiterplatte von Fig. 1.

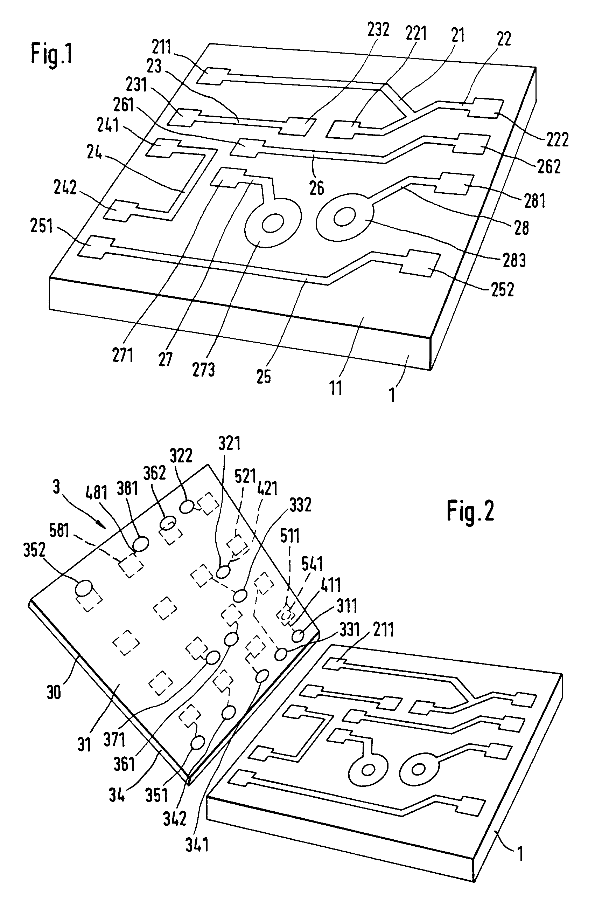

In Fig. 1 ist eine noch nicht mit elektronischen Komponenten bestückte Leiterplatte 1, die im eingangs erwähnten Sinn getestet werden muß, mit einem einfachen Layout perspektivisch gezeigt. Die Leiterplatte 1 hat eine nicht zu sehende Unterseite und eine Oberseite 11 und ist darauf mit acht Leiterbahnen 21, 22, 23, 24, 25, 26, 27, 28 versehen.

Die Leiterbahn 21 ist somit eine erste Leiterbahn, die Leiterbahn 22 eine zweite Leiterbahn und die Leiterbahn 28 eine m-te Leiterbahn. Von diesen Leiterbahnen mündet die Leiterbahn 21 in die Leiterbahn 22, während die restlichen miteinander nicht verbundene selbständige Leiterbahnen sind. Es sind somit in Fig. 1 m = 8 Leiterbahnen vorhanden

Die Leiterbahn 21 ist an ihrem einzigen Ende mit einem ersten Testpunkt 211 und die Leiterbahn 22 an ihrem einen Ende mit einem zweiten Testpunkt 221 versehen. Ein weiterer Testpunkt 222 befindet sich am anderen Ende der Leiterbahn 22; weitere Testpunkte 231, 232; 241, 242; 251, 252; 261, 262 befinden sich an den Enden der Leiterbahnen 23, 24, 25, 26. Die Leiterbahnen 27, 28 haben jeweils nur einen Testpunkt 271, 281; der Testpunkt 281 ist ein n-ter Testpunkt. Alle diese Testpunkte sind in Fig. 1 rechteckig dargestellt. In Fig. 1 sind n = 13 Testpunkte vorhanden.

Ferner sind noch zwei kreisförmige Anschlußflächen 273, 283 gezeigt, über die durch die Leiterplatte hindurch die elektrische Verbindung zu eventuell vorhandenen, nicht zu sehenden Leiterbahnen auf der Unterseite der Leiterplatte 1 hergestellt werden kann. Das ist z.B. durch vom Hersteller der Leiterplatte bereits erzeugte Durchmetallisierungen oder erst vom Anwender der Leiterplatte mittels einer einzulötenden Komponente relisierbar.

An mindestens einem Teil der Testpunkte werden vom Benutzer der Leiterplatte nach deren Auslieferung elektronische Komponenten, wie z.B. MELF- oder MiniMELF-Komponenten angebracht. Die Leiterplatte 1 ist in Fig. 1 einlagig dargestellt, was jedoch nicht zwingend ist.

Die Testpunkte sind während des Testvorgangs mittels einer Adapteranordnung an ein nicht dargestelltes Testgerät anzuschließen, das von üblicher Bauart ist, so daß auf seine Darstellung und Erläuterung hier verzichtet werden kann.

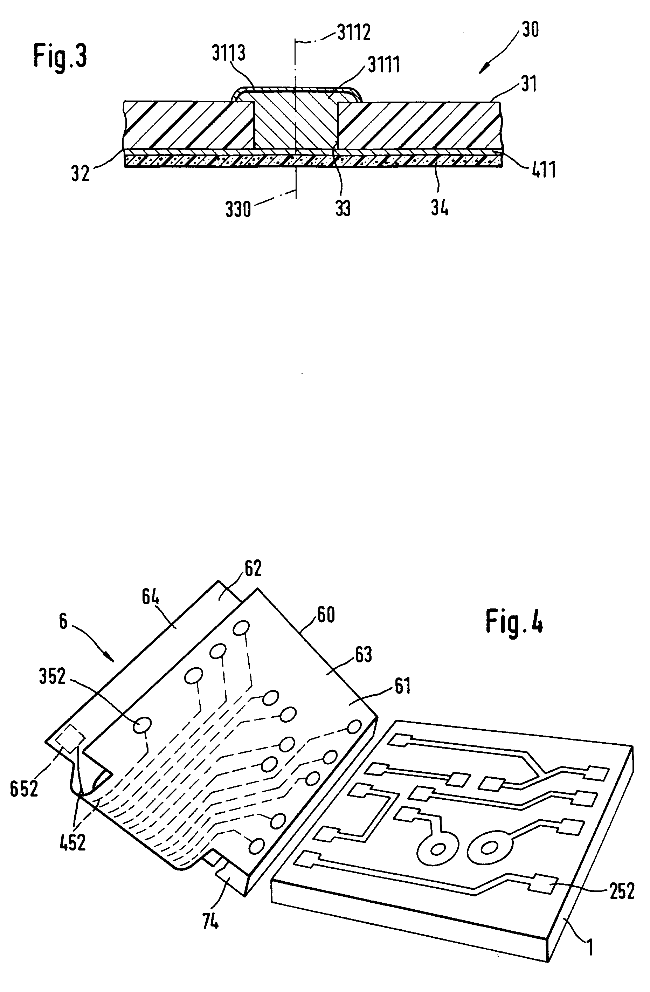

In Fig. 2 ist perspektivisch und zusammen mit der Leiterplatte 1 von Fig. 1 eine erste Variante einer Adapteranordnung 3 dargestellt. Diese umfaßt eine einschichtige flexible Folie 30 aus Isoliermaterial, z.B. aus einem Polyimid, die eine Vorderseite 31 und eine nur in Fig. 3 zu sehende Rückseite 32 hat.

Auf und/oder in der Folie 30 sind ein erster, ein zweiter und ein n-ter elektrisch leitender Kontaktbump 311, 321, 381 angeordnet. Ferner sind zehn weitere Kontaktbumps 322; 331, 332; 341, 342; 351, 352; 361, 362; 371 vorhanden. Die Bezugszeichen der Kontaktbumps sind so gewählt, daß ihre letzten beiden Ziffern den letzten beiden Ziffern der Bezugszeichen der Testpunkte 222; 231, 232; 241, 242; 251, 252; 261, 262; 271 gleich sind.

Alle n = 13 Kontaktbumps sind auf der Vorderseite 31 der Folie 30 genau spiegelbildlich zu der flächenmäßigen Anordnung der n = 13 Testpunkte auf der Leiterplatte 1 angeordnet. Wenn während des Testens die Vorderseite 31 der Folie 3 mit der Oberseite 11 der Leiterplatte 1 durch Auflegen mechanisch in Berührung gebracht und nach einem entsprechenden Ausrichten flächig, z.B. mittels eines Stempels, daran angedrückt wird, kontaktieren die "zueinander gehörenden" Kontaktbumps "ihre" Testpunkte elektrisch.

Auf der Rückseite der Folie 30 ist der erste Kontaktbump 311 mittels eines ersten Leiterzugs 411 mit einem ersten Kontaktpunkt 511 verbunden. In gleicher Weise sind der zweite Kontaktbump 321, der n-te Kontaktbump 381 und die weiteren Kontaktbumps 322; 331, 332; 341, 342; 351, 352; 361, 362; 371 über einen zweiten Leiterzug 421 bzw. einen n-ten Leiterzug 481 bzw. weitere Leiterzüge mit einem zweiten Kontaktpunkt 521 bzw. einem n-ten Kontaktpunkt 581 bzw. mit weiteren Kontaktpunkten verbunden. Der Übersichtlichkeit halber sind den weiteren Leiterzügen und den weiteren Kontaktpunkten keine Bezugszeichen zugeordnet.

Die Bezugszeichen der Leiterzüge sind so gewählt, daß ihre letzten beiden Ziffern den letzten beiden Ziffern der Bezugszeichen der Testpunkte 211, 221 222, 231, 232, 241, 242, 251, 252, 261, 262, 271, 281 und der Kontaktbumps 311, 321, 322, 331, 332, 341, 342, 351, 352, 361, 362, 371, 381 gleich sind.

Beim Testen sind der erste Kontaktpunkt 511 mit einer ersten Kontaktnadel eines Eingangskontaktfelds des Testgeräts, der zweite Kontaktpunkt 521 mit einer zweiten Kontaktnadel des Eingangskontaktfelds, der n-te Kontaktpunkt 581 mit einer n-ten Kontaktnadel und die weiteren Kontaktpunkte von jeweils einer entsprechenden weiteren Kontaktnadel des Eingangskontaktfelds elektrisch zu kontaktieren.

Dies geschieht dadurch, daß das Eingangskontaktfeld an die Rückseite 32 der Folie 30 unter Zwischenlage einer elektrisch isolierenden, elastisch federnden Zwischenfolie 34 gedrückt wird. Diese ist dort, wo eine Kontaktnadel einen Kontaktpunkt zu kontaktieren hat, mit einer elektrischen Durchkontaktierung 541 versehen.

Das in Fig. 2 der Einfachheit halber nicht dargestellte Eingangskontaktfeld des Testgeräts hat eine in Zeilen und Spalten regelmäßige Anordnung der erwähnten Kontaktnadeln. Zu dieser Anordnung spiegelbildlich ist die flächenmäßige Verteilung der Kontaktpunkte, zu denen die Kontaktpunkte 511, 521, 581 gehören.

Die Fig. 3 zeigt den Aufbau der Kontaktbumps im Schnitt und stark vergrößert, und zwar anhand des Kontaktbumps 311 von Fig. 2. Der Kontaktbump hat einen Kontaktierungsteil 3111 sowie eine Längsachse 3112. Er führt senkrecht von der Rückseite 32 zur Vorderseite 31 durch die Folie 30 in einer Bohrung 33 hindurch, die eine Mittelachse 330 hat.

Üblicherweise wird ein derartiger Kontaktbump dadurch in der Bohrung 33 erzeugt, daß darin, ausgehend vom an der Rückseite 32 vorhandenen Leiterzug 411, galvanisch oder außenstromlos Kupfer über den Rand an der Vorderseite 31 der Bohrung 33 hinaus wachsen gelassen wird. Dadurch bildet sich ein Kontaktierungsteil 3111, der die Vorderseite 31 einstufig überragt und derart in der Bohrung 33 sitzt, daß die Längsachse 3112 mit der Mittelachse 330 zusammenfällt. Die Oberfläche des Kontaktierungsteils 3111 ist mit einer Nickel-Gold-Schicht 3113 plattiert.

In Fig. 3 ist ferner wegen der besseren Darstellbarkeit als in Fig. 2 gezeigt, daß eine elektrisch isolierende, elastisch federnde Zwischenfolie 34 an der Rückseite 32 der Folie 30 angeordnet ist, die dort z.B. mechanisch fest verbunden sein und z.B. aus einem geeigneten Schaumstoff bestehen kann. Somit schmiegt sich die Folie 30 beim erwähnten Andrücken während des Testens sehr gut an die Leiterplatte 1 an, selbst wenn diese recht uneben sein sollte.

Die erste Variante der Erfindung nach Fig. 2 kann auch bei zweiseitigen Leiterplatten angewendet werden. In diesem Fall ist für die Unterseite der zweiseitigen Leiterplatte eine der Adapteranordnung 3 entsprechende weitere Adapteranordnung vorzusehen. Diese ist beim Testen mittels einer der Zwischenfolie 34 entsprechenden weiteren Zwischenfolie an das Eingangskontaktfeld des Testgeräts anzudrücken.

Die Fig. 4 zeigt perspektivisch eine Adapteranordnung 6 entsprechend einer zweiten Variante der Erfindung zusammnen mit der Leiterplatte von Fig. 1. Die Adapteranordnung 6 ist im wesentlichen eine einschichtige flexible Folie 60 aus Isoliermaterial mit einer Vorderseite 61 und einer Rückseite 62 sowie mit einem ersten Teil 63 und einem damit zusammenhängenden zweiten Teil 64.

Auf der Vorderseite 61 sind im ersten Teil 63 wie bei der Folie 30 von Fig. 2 Kontaktbumps zur Kontaktierung der Testpunkte der Leiterplatte 1 vorgesehen. Auf der Rückseite 62 sind wieder Leiterzüge vorgesehen, die mit den einzelnen Kontaktbumps elektrisch verbunden sind. So gehört z.B. der Kontaktbump 352 zum Leiterzug 452 und zum Testpunkt 252.

Die Leiterzüge erstrecken sich auch in den zweiten Teil 64 der Folie 60 und enden dort in zugehörigen Vorderseiten-Kontaktpunkten; von diesen ist in Fig. 4 nur der zum Kontaktbump 352 gehörende Vorderseiten-Kontaktpunkt 652 dargestellt.

Beim Testen werden die einzelnen Vorderseiten-Kontaktpunkte mit einer entsprechenden Kontaktnadel des bereits in Zusammenhang mit Fig. 2 erwähnten Eingangskontaktfelds des Testgeräts elektrisch kontaktiert. Daher ist die fächenmäßige Verteilung der Vorderseiten-Kontaktpunkte auch hier spiegelbildlich zur Anordnung der Kontaktnadeln.

Das Kontaktieren erfolgt, indem der zweite Teil 64 der Folie 60 um ca. 180° gewendet wird und indem das Eingangskontaktfeld an die Vorderseite 61 der Folie 60 im zweiten Teil 64 angedrückt, und zwar unter Zwischenlage einer elektrisch isolierenden, elastisch federnden Zwischenfolie 74 zwischen den ersten Teil 63 und den zweiten Teil 64 der Rückseite 62 der Folie 60.

Die Zwischenfolie 74 ist in Fig. 5 nur teilweise dargestellt, damit sie andere Figurenteile nicht überdeckt. Bei der Adapteranordnung 6 übt die Zwischenfolie 74 ihre Unebenheiten ausgleichende Funktion sowohl auf den ersten Teil 63 und die Leiterplatte 1 als auch auf den zweiten Teil 64 und das Eingangskontaktfeld aus.

Auch die zweite Variante der Erfindung nach Fig. 4 kann zusammen mit zweiseitigen Leiterplatten angewendet werden. Hierbei ist für die Rückseite der zweiseitigen Leiterplatte eine der Adapteranordnung 6 entsprechende weitere, zweiteilige Adapteranordnung vorzusehen. Diese ist beim Testen durch 180°-Wenden und mittels einer der Zwischenfolie 74 entsprechenden weiteren Zwischenfolie an das Eingangskontaktfeld des Testgeräts anzudrücken.

Folgende Materialien werden bei der Erfindung bevorzugt verwendet:
- Handelsübliche Polyimidfolie als Material der Folien,
- Kupfer-Folie als Material der Leiterbahnen,
- galvanisch oder außenstromlos abgeschiedenes Kupfer als Metallisierung der Füllung der Bohrungen,
- galvanisch oder außenstromlos abgeschiedenes Nickel/Gold als Material der Kontaktbumps,
- handelsübliche nichtleitende Polymerfolien als Material der Zwischenfolien,
- handelsübliche gefederte Stifte oder flexible Zylinder aus elektrisch leitfähigen elastischen Polymeren als Material der Durchkontaktierungen entsprechend Fig. 2.

Folgende Herstellungsverfahren werden bei der Erfindung bevorzugt verwendet:
- Strukturieren der Bohrungen mittels üblichem Plasmaätzen oder Laserbohren oder Photolithographie,
- Strukturieren der Kontaktbumps und der Leiterbahnen mittels Photolithographie und galvanischer oder außenstromloser Metallisierung.

## Patentansprüche

1. Adapteranordnung (3) zum elektrischen Anschluß von zu testenden, mindestens einlagigen, unbestückten Leiterplatten (1) an ein Testgerät, die einen ersten, einen zweiten und einen n-ten Testpunkt (211, 221, 281) aufweisen, wobei n eine beliebig vorgebbare ganze Zahl ist, welche Adapteranordnung umfaßt:
- eine einschichtige flexible Folie (30) aus einem Isoliermaterial
-- mit einer Vorderseite (31) und einer Rückseite (32),
-- mit einem ersten, einem zweiten und einem n-ten elektrisch leitenden Kontaktbump (311, 321, 381) mit einem Kontaktierungsteil (3111) und einer Längsachse (3112), welcher Kontaktbump
--- von der Rückseite zur Vorderseite durch die Folie in einer Bohrung (33), die eine Mittelachse (330) hat, senkrecht hindurchführt,
--- die Vorderseite einstufig überragt und
--- derart in der Bohrung sitzt, daß die Längsachse mit deren Mittelachse zusammenfällt, und
--- von welchen Kontaktbumps während des Testens der erste Kontaktbump (311) mit dem ersten Testpunkt (211), der zweite Kontaktbump (321) mit dem zweiten Testpunkt (221) und der n-te Kontaktbump (381) mit dem n-ten Testpunkt (281) durch flächiges Andrücken der Folie (30) an die Leiterplatte (1) mechanisch in Berührung zu bringen und dadurch elektrisch zu kontaktieren ist,
-- mit einem den ersten Kontaktbump (311) kontaktierenden, auf der Rückseite der Folie zu einem ersten Kontaktpunkt (511) verlaufenden ersten Leiterzug (411),
-- mit einem den zweiten Kontaktbump (321) kontaktierenden, auf der Rückseite der Folie zu einem zweiten Kontaktpunkt (521) verlaufenden zweiten Leiterzug (421),
-- mit einem den n-ten Kontaktbump (381) kontaktierenden, auf der Rückseite der Folie zu einem n-ten Kontaktpunkt (581) verlaufenden n-ten Leiterzug (481),
--- von denen der erste Kontaktpunkt (511) mit einer ersten Kontaktnadel eines Eingangskontaktfelds des Testgeräts, der zweite Kontaktpunkt (521) mit einer zweiten Kontaktnadel des Eingangskontaktfelds und der n-te Kontaktpunkt (581) mit einer n-ten Kontaktnadel des Eingangskontaktfelds mittels dessen Andrückens an die Rückseite der Folie (30) unter Zwischenlage einer elektrisch isolierenden, elastisch federnden Zwischenfolie (34) elektrisch zu kontaktieren ist,
---- die dort, wo eine Kontaktnadel einen Kontaktpunkt zu kontaktieren hat, eine elektrische Durchkontaktierung aufweist (Fig. 2).

2. Adapteranordnung (6) zum elektrischen Anschluß von zu testenden, mindestens einlagigen, unbestückten Leiterplatten (1) an ein Testgerät, die einen ersten, einen zweiten und einen n-ten Testpunkt (252) aufweisen, wobei n eine beliebig vorgebbare ganze Zahl ist, welche Adapteranordnung umfaßt:
- eine einschichtige flexible Folie (60) aus einem Isoliermaterial
-- mit einer Vorder- und einer Rückseite (61, 62) sowie mit einem ersten und einem damit zusammenhängenden zweiten Teil (63, 64),
-- mit einem ersten, einem zweiten und einem n-ten elektrisch leitenden Kontaktbump (352) mit einem Kontaktierungsteil (3111) und einer Längsachse (3112), welcher Kontaktbump
--- im ersten Teil (63) der Folie angeordnet ist,
--- von der Rückseite zur Vorderseite durch die Folie in einer Bohrung (33), die eine Mittelachse (330) hat, senkrecht hindurchführt,
--- die Vorderseite einstufig überragt und
--- derart in der Bohrung sitzt, daß die Längsachse mit deren Mittelachse zusammenfällt, und
--- von welchen Kontaktbumps während des Testens der erste Kontaktbump mit dem ersten Testpunkt, der zweite Kontaktbump mit dem zweiten Testpunkt und der n-te Kontaktbump mit dem n-ten Testpunkt durch flächiges Andrücken der Folie an die Leiterplatte mechanisch in Berührung zu bringen und dadurch elektrisch zu kontaktieren ist,
-- mit einem den ersten Kontaktbump kontaktierenden, auf der Rückseite der Folie verlaufenden ersten Leiterzug,
-- mit einem den zweiten Kontaktbump kontaktierenden, auf der Rückseite der Folie verlaufenden zweiten Leiterzug,
-- mit einem den n-ten Kontaktbump kontaktierenden, auf der Rückseite der Folie verlaufenden n-ten Leiterzug (452), von denen
--- der erste Leiterzug bis zu einem ersten, im zweiten Teil der Folie liegenden Vorderseiten-Kontaktpunkt führt und mit diesem durch die Folie hindurch kontaktiert ist,
--- der zweite Leiterzug bis zu einem zweiten, im zweiten Teil der Folie liegenden Vorderseiten-Kontaktpunkt (652) führt und mit diesem durch die Folie hindurch kontaktiert ist, und
--- der n-te Leiterzug bis zu einem n-ten, im zweiten Teil der Folie liegenden Vorderseiten-Kontaktpunkt führt und mit diesem durch die Folie hindurch kontaktiert ist, wobei
---- der erste Vorderseiten-Kontaktpunkt mit einer ersten Kontaktnadel eines Eingangskontaktfelds des Testgeräts, der zweite Vorderseiten-Kontaktpunkt mit einer zweiten Kontaktnadel des Eingangskontaktfelds und der n-te Vorderseiten-Kontaktpunkt mit einer n-ten Kontaktnadel des Eingangskontaktfelds durch Wenden des zweiten Teils der Folie um ca. 180° und mittels Andrückens des Eingangskontaktfelds an die Vorderseite der Folie im zweiten Teil unter Zwischenlage einer elektrisch isolierenden, elastisch federnden Zwischenfolie (74) zwischen die Rückseite der Folie in deren erstem und zweitem Teil elektrisch zu kontaktieren ist (Fig. 4).

3. Adapteranordnung nach Anspruch 1, bei der die Durchkontaktierungen in Form von in Längsrichtung federnden Stiften oder in Form von elastischen leitenden Zylindern realisiert sind.
